# EUROPÄISCHE PATENTSCHRIFT

(11) **EP 3 649 834 B1**
(45) Veröffentlichungstag und Bekanntmachung des Hinweises auf die Patenterteilung: **14.07.2021**
(21) Anmeldenummer: 18738276.7
(22) Anmeldetag: 04.07.2018
(51) Int. Cl.: H05K 3/40, H05K 1/03, H05K 1/09, H05K 3/12, H05K 3/46, H05K 1/16

(54) **VERFAHREN ZUR HERSTELLUNG EINER DURCHKONTAKTIERUNG IN EINER AUS EINER KERAMIK GEFERTIGTEN TRÄGERSCHICHT UND TRÄGERSCHICHT MIT DURCHKONTAKTIERUNG**
METHOD FOR PRODUCING A VIA IN A CARRIER LAYER PRODUCED FROM A CERAMIC AND CARRIER LAYER HAVING A VIA
PROCÉDÉ DE RÉALISATION D'UNE MÉTALLISATION DE TROU TRAVERSANT DANS UNE COUCHE PORTEUSE FABRIQUÉE EN UNE CÉRAMIQUE ET COUCHE PORTEUSE AVEC MÉTALLISATION DE TROU TRAVERSANT

(30) Priorität: 04.07.2017 DE 102017114891
(43) Veröffentlichungstag der Anmeldung: 13.05.2020
(73) Patentinhaber: Rogers Germany GmbH, 92676 Eschenbach (DE)
(72) Erfinder: SCHMIDT, Karsten, 92676 Eschenbach (DE); BRITTING, Stefan, 91220 Schnaittach (DE); MEYER, Andreas, 95469 Speichersdorf (DE); HERRMANN, Rainer, 95485 Warmensteinach (DE); REGER, Martin, 95505 Immenreuth (DE)
(74) Vertreter: Müller Schupfner & Partner Patent- und Rechtsanwaltspartnerschaft mbB
(86) Internationale Anmeldenummer: PCT/EP2018/068022
(87) Internationale Veröffentlichungsnummer: WO 2019/008004

(56) Entgegenhaltungen:
- EP-A1- 1 478 216
- EP-A1- 2 555 602
- DE-A1- 4 103 294
- DE-A1- 19 930 190
- DE-A1-102006 060 634
- DE-A1-102012 219 904

## Beschreibung

Die vorliegende Erfindung betrifft ein Verfahren zur Herstellung einer Durchkontaktierung in einer aus einer Keramik gefertigten Trägerschicht und eine Trägerschicht mit Durchkontaktierung.

Solche Trägersubstrate sind beispielsweise als Leiterplatten oder Platinen bekannt. Typischerweise werden auf einer Trägeroberseite des Trägersubstrats Metallisierungen angeordnet, die später zur Ausbildung von Leiterbahnen genutzt werden können. Für Spezialanwendungen haben sich solche Trägerschichten als besonders vorteilhaft erwiesen, die zur elektrischen Isolation der einzelnen elektrischen Bauteile und Leiterbahnen eine Isolationsschicht mit hoher elektrischer Isolationsfestigkeit aufweisen, wie z.B. eine aus Keramik gefertigte Trägerschicht.

Um eine möglichst kompakte Anordnung von elektrischen bzw. elektronischen Bauteilen zu ermöglichen und parasitäre Induktionseffekte zu vermindern bzw. zu unterdrücken, erweist es sich als sinnvoll, wenn eine zusätzliche Metallisierung nicht nur auf der Trägeroberseite sondern auch auf der der Trägeroberseite gegenüberliegenden Trägerunterseite angebunden wird und die einander gegenüberliegenden Metallisierungen z.B. über eine durch die Trägerschicht hindurchlaufende Durchkontaktierung miteinander elektrisch leitenden verbunden werden. Beispiele sind hierfür sind aus der DE 197 53 149 A1 oder der DE 19 945 794 C2 bekannt.

Aus der JP H06 - 13 726 A ist ein Keramik-Substrat mit einer Durchkontaktierung bekannt. Dabei wird beim Anbinden der Metallisierung an der Oberseite die Durchkontaktierung realisiert. Hierzu wird eine silber- und kupferhaltige Paste in eine entsprechende Bohrung eingelassen.

Aus der EP 1 478 216 A1 ist ein Verfahren bekannt, bei dem eine Paste in eine Durchgangsbohrung eingebracht wird und vor dem Aufbringen der Kupferfolie ausgehärtet wird.

Aus der DE 41 03 294 A1 ist ein Verfahren bekannt geworden, bei dem eine Paste in eine Durchgangsbohrung eingebracht wird. Beim Aufbringen der Kupferfolie zieht die schmelzende Paste aufgrund ihrer Kapillarwirkung die Kupferfolie in die Durchgangsbohrung.

Es ist eine Aufgabe der vorliegenden Erfindung, ein gegenüber den aus dem Stand der Technik bekannten Verfahren verbessertes Verfahren bereitzustellen, mit dem sich diese Durchkontaktierungen einfach und kontrolliert herstellen lassen.

Diese Aufgabe wird gelöst durch ein Verfahren zur Herstellung einer Durchkontaktierung in einer aus einer Keramik gefertigten Trägerschicht gemäß Anspruch 1. Weitere Vorteile und Merkmale der Erfindung ergeben sich aus den Unteransprüchen sowie der Beschreibung und den beigefügten Figuren.

Erfindungsgemäß ist ein Verfahren zur Herstellung einer Durchkontaktierung in einer aus einer Keramik gefertigten Trägerschicht, vorgesehen, umfassend:
- Bereitstellen der Trägerschicht,
- Realisieren einer Durchgangsaussparung in der Trägerschicht,
- zumindest teilweises Füllen der Durchgangsaussparung mit einer Paste und
- Durchführen eines Anbindungsverfahrens zur Anbindung einer Metallisierung an die Trägerschicht, mittels eines Aktivlot-Verfahrens oder eines DCB-Verfahrens,
- wobei beim Durchführen des Anbindungsverfahrens aus der Paste in der Durchgangsaussparung die Durchkontaktierung realisiert wird.

Im Gegensatz zu den Verfahren aus dem Stand der Technik wird mit Vorteil die Durchkontaktierung während des Aktivlot-Verfahrens zum Anbinden der Metallisierung an die Trägerschicht hergestellt. Durch die zeitgleiche Ausbildung der Durchkontaktierung wird mit Vorteil ein andernfalls erforderlicher zusätzlicher Arbeitsschritt eingespart, mit dem die Durchkontaktierung ausgebildet wird. Dabei wird insbesondere beim Aktivlot-Verfahren ausgenutzt, dass die beim Durchführen des Aktivlot-Verfahrens verwendeten Temperaturen auch zur Ausbildung der Durchkontaktierung genutzt werden können. Dabei ist es insbesondere vorgesehen, dass die Paste ein Aktivlotmaterial umfasst. Dabei kann es sich um dasselbe Aktivlotmaterial handeln, das zur Ausbildung der Verbindung zwischen der Trägerschicht und der Metallisierung verwendet wird, oder um ein anderes Lotmaterial, wie z. B. ein glasgefülltes Hartlot, insbesondere auf der Basis von AgCu. Im Falle einer Anbindung der Metallisierung mittels eines DCB- Verfahrens wird vorzugsweise eine Paste verwendet, deren Schmelzbereich unterhalb derjenigen Temperatur liegt, die im DCB-Verfahren vorgesehen ist.

Insbesondere ist es vorgesehen, dass die Trägerschicht Al₂O₃, Si₃N₄, AlN oder eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25) aufweist. Vorzugsweise weist die Trägerschicht eine Trägeroberseite und eine Trägerunterseite auf, auf die jeweils Metallisierungen anbringbar sind. Ein Abstand zwischen der Trägeroberseite und der Trägerunterseite, d. h. eine Dicke der Trägerschicht, nimmt beispielsweise einen Wert zwischen 30 µm und 3 mm an. Die Metallisierung ist beispielsweise aus Kupfer, einer Kupferlegierung, Molybdän Mo, Wolfram W, einem Verbundmaterial oder Vergleichbarem gefertigt und weist eine Dicke zwischen 30 µm und 3 mm auf. Zur Ausbildung von Laufbahnen bzw. Anschlussbereichen werden die auf der Trägerschicht aufgetragenen Metallisierungen vor und/oder nach dem Fügeprozess zumindest teilweise strukturiert, z.B. weggeätzt, um einzelne Bereiche der Metallisierung voneinander elektrisch zu isolieren.

Vorzugsweise handelt es sich bei der Durchgangsaussparung um eine Durchgangsbohrung, die im Falle einer bereits gesinterten Keramik mechanisch und/oder optisch, beispielsweise mittels Laserlicht, in die Trägerschicht eingelassen wird.

Unter einem "DCB-Verfahren" (Direct-Copper-Bond-Technology) versteht der Fachmann ein solches Verfahren, das beispielsweise zum Verbinden von Metallisierungen oder -blechen (z. B. Kupferblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht) aus einer chemischen Verbindung aus dem Metall und einem reaktiven Gas, bevorzugt Sauerstoff, aufweisen. Bei diesem beispielsweise in der US-PS 37 44 120 oder in der DE-PS 23 19 854 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1065°C bis 1083°C, z. B. auf ca. 1071°C;
- Abkühlen auf Raumtemperatur.

Unter einem Aktivlot-Verfahren, z. B. zum Verbinden von Metallisierungen oder Metallfolien, insbesondere auch von Kupferschichten oder Kupferfolien mit Keramikmaterial, ist ein Verfahren zu verstehen, welches speziell auch zum Herstellen von Metall-Keramik-Substraten verwendet wird. Hierbei wird bei einer Temperatur zwischen ca.650-1000 °C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist.

Gemäß einer weiteren Ausführungsform der vorliegenden Erfindung ist es vorgesehen, dass durch das Verfahren ein bestimmter elektrischer Widerstand der Durchkontaktierung eingestellt wird. Beispielsweise wird der elektrische Widerstanderstand durch die Größe der Durchgangsaussparung und/oder einen Füllgrad der Durchgangsbohrung eingestellt. Dadurch lässt sich mit Vorteil gezielt ein elektrischer Widerstand erzielen. Insbesondere lässt sich die Auswahl von Größe und/oder Füllgrad der Durchgangsaussparung an die jeweiligen Ausdehnungskoeffizienten der Trägerschicht einerseits und einer die Durchkontaktierung bildenden Beschichtung bzw. Füllung andererseits anpassen, um eine Wahrscheinlichkeit für das Ausbilden von thermomechanischen Spannungen in der gefertigten Trägerschicht zu reduzieren.

In einer weiteren Ausführungsform der vorliegenden Erfindung ist es vorgesehen, dass ein elektrischer Widerstand der Durchkontaktierung durch Einstellen eines oder mehrerer Prozessparameter des Anbindungsverfahrens eingestellt wird. Dadurch lässt sich mit Vorteil ohne großen zusätzlichen Aufwand der elektrische Widerstand der Durchkontaktierung einstellen. Beispielsweise wird durch ein Aushärtender Paste während des Anbindungsverfahrens ein elektrisch wirksamer Füllgrad der Durchgangsaussparung bzw. die Wandstärke des Füllmetalls in der Durchgangsaussparung geändert. Vorzugsweise werden hierzu Pasten verwendet, die ein Glaslot oder ein keramisches Pulver umfassen bzw. mit diesen gefüllt sind, wobei das Glaslot bzw. das keramische Pulver im Anbindungsverfahren eine Matrix aus nichtleitendem Material darstellt.

Zweckmäßig ist es vorgesehen, dass eine Innenseite der Durchgangsaussparung mit einer Paste bedeckt wird, wobei die Durchgangsaussparung vorzugsweise zumindest teilweise, bevorzugt vollständig gefüllt ist. Durch die Bedeckung bzw. Beschichtung der Innenseite der Durchgangsbohrung wird die Paste mit Vorteil in dem Bereich angebracht, in dem die Paste nach dem Verfahren die Durchkontaktierung bildet. Dabei ist es vorstellbar, dass die Paste nur einen Teil der Innenseite der Durchgangsaussparung bedeckt. Um später eine elektrisch leitende Verbindung zwischen der Trägeroberseite und der Trägerunterseite bereitstellen zu können, erstreckt sich die Paste durchgehend von der Trägeroberseite bis zur Trägerunterseite. Vorzugsweise ist die Durchgangsaussparung teilweise am Rand oder vollständig mit der Paste gefüllt. Dadurch wird eine möglichst stabile Durchkontaktierung bereitgestellt. Außerdem erweist sich das vollständige Füllen mit der Paste einfacher als ein Verfahren, bei dem ein Metallblock zur Bildung der Durchkontaktierung in die Durchgangsaussparung eingelassen wird. Es ist auch vorstellbar, dass ein Füllgrad der Durchgangsaussparung durch das Anbindungsverfahren, insbesondere durch die gewählten Parameter des Anbindungsverfahrens, im gefertigten Zustand reduziert ist gegenüber dem Füllgrad beim Befüllen bzw. unmittelbar nach dem Befüllen der Durchgangsbohrung. Insbesondere ist es vorstellbar, dass sich während des Anbindungsverfahrens ein in der Durchkontaktierung eingeschlossener Hohlraum ausbildet. Besonders bevorzugt ist es vorgesehen, wenn der Füllgrad nach dem Anbindungsverfahren einen Wert zwischen 20 % und 100 %, bevorzugt zwischen 40 % und 100 % und besonders bevorzugt zwischen 60 % und 100 % annimmt. Unter Füllgrad versteht der Fachmann insbesondere ein Verhältnis zwischen einem materialgefüllten Volumenanteil zum Gesamtvolumen der ungefüllten Durchgangsaussparung. Dabei ist die ungefüllte Durchgangsaussparung durch die Trägerschicht begrenzt und endet jeweils bündig mit der Trägerunterseite und/oder Trägeroberseite.

Gemäß einer weiteren Ausführungsform der vorliegenden Erfindung ist es vorgesehen, dass die Durchgangskontaktierung als Beschichtung der Innenseite der Durchgangsaussparung mit einer Beschichtungsdicke ausgebildet wird, wobei das Anbindungsverfahren bestimmende Parameter derart eingestellt werden, dass sich eine bestimmte Beschichtungsdicke einstellt. Bei einer vorgegebenen Pastenmenge, die auf die Innenseite der Durchgangsbohrung aufgetragen wird, ist z. B. der Prozessdruck in einem Rezipient maßgeblich für die Ausbildung eines Hohlraums in der Durchkontaktierung. Für eine vollständige Füllung der Durchkontaktierung ist ein möglichst niedriger Druck im Bereich unterhalb von 1mbar, bevorzugt unterhalb von 10⁻² mbar, besonders bevorzugt unterhalb von 10⁻⁴ mbar nötig. Um hingegen einen Hohlraum durch eine nicht vollständig mit Paste gefüllte Durchgangsaussparung zu erreichen, ist neben dem Prozessdruck, eine möglichst geringe Verweilzeit der Pastenbestandteile des verfahrensgemäßen Anbindungsverfahrens im Schmelzbereich von weniger als 60 min, bevorzugt von weniger als 30 min und besonders bevorzugt von weniger als 10 min nötig, um ein Abdiffundieren der geschmolzenen Pastenbestandteile in die Metallisierung zu verhindern. Bei längerer Verweilzeit des Lotes (Aktivlot oder CuO) im schmelzflüssigen Zustand, insbesondere bei Verweilzeiten von mehr als 10 min, diffundieren mit zunehmender Zeit die schmelzpunkterniedrigenden Zusatzstoffe in die Metallisierung und würden so das die Durchkontaktierung bildende metallische Volumen verringern. Durch die Beschichtungsdicke wird mit Vorteil der elektrische Widerstand der Durchkontaktierung eingestellt. Insbesondere ist es vorstellbar, dass ein Verhältnis aus einer Beschichtungsdicke und einem durch die Innenseite der Durchgangsaussparung festgelegten Durchmesser einen Wert zwischen 0,05 und 0,5, vorzugsweise zwischen 0,1 und 0,45 und besonders bevorzugt zwischen 0,15 und 0,35 annimmt.

In einer weiteren Ausführungsform der vorliegenden Erfindung ist es vorgesehen, dass eine Paste mit Zusatzmaterial, insbesondere mit einem eine Schmelztemperatur senkenden Zusatzmaterial, verwendet wird. Dadurch lässt sich mit Vorteil sicherstellen, dass die Paste bei den im Anbindungsverfahren auftretenden Temperaturen schmilzt und anschließend zur Ausbildung der Durchkontaktierung aushärtet. Vorzugsweise basiert ein im Aktivot-Verfahren verwendetes Aktivlot auf einer eutektischen Mixtur aus Silber und Kupfer, deren Schmelztemperatur bei im Wesentlichen 780 °C liegt und eine Zusammensetzung aus 72 Gew-% (Ag) zu 28 Gew.% (Cu) aufweist. Vorzugsweise ist dem Aktivlot ein Aktivmetall, wie z. B. Ti, Zr, und/oder Hf zugesetzt.

Vorzugsweise ist es vorgesehen, dass das Zusatzmaterial Indium, Zinn und/oder Gallium umfasst, vorzugweise in einer Konzentration von 0,1 bis 20 Gew. - %, bevorzugt in einer Konzentration von 0,25 bis 15 Gew. - % und besonders bevorzugt in einer Konzentration von 0,5 bis 10 Gew. - %. Durch das Einstellen dieser Konzentrationen lassen sich die Fließeigenschaften des Aktivlots mit Vorteil beeinflussen. Hierbei hat sich insbesondere das Konzentrationsintervall zwischen 0,5 und 10 Gew. - % als vorteilhaft in Hinblick auf das Fließverhalten beim Ausbilden der Durchkontaktierung bzw. beim Füllen der Durchgangsaussparung herausgestellt. Vorzugsweise ist die Konzentration des Zusatzmaterials an den gewünschten Füllgrad der Durchgangsbohrung angepasst.

In einer weiteren Ausführungsform der vorliegenden Erfindung ist es vorgesehen, dass die Paste mittels einem Druckverfahren, insbesondere einem 3D-Druckverfahren, und/oder einem Siebdruckverfahren und/oder Schablonendruck aufgetragen wird. Es ist vorstellbar, dass eine Verschlussschicht beim Befüllen, insbesondere beim Befüllen mittels Siebdruckverfahren, vorgesehen ist, wobei die Verschlussschicht die Durchgansaussparung zu einer Seite hin begrenzt und verhindert, dass beim Befüllen die Paste austritt. Vorzugsweise ist die Durchgansaussparung aus einem porösen Material oder einem nicht-porösen Material gefertigt. Die Nutzung eines porösen Materials erlaubt ein Anwenden eines Vakuums, mit dem die Paste in die Durchgangsaussparung hineingezogen wird. Es ist auch denkbar, dass die Verschlussschicht beabstandet zur Trägerobseite und/oder Trägerunterseite ausgebildet ist, um die Verbindung zwischen der Durchkontaktierung und der Metallisierung zu vereinfachen.

Gemäß einer weiteren Ausführungsform der vorliegenden Erfindung ist es vorgesehen, dass die Durchgangsaussparung einen Durchmesser zwischen 0,01 mm und 5 mm, bevorzugt zwischen 0,03 und 2,5 mm und besonders bevorzugt zwischen 0,05 mm und 2 mm aufweist. Insbesondere für Durchgangsaussparungen mit einem Durchmesser zwischen 0,05 und 2,5 mm werden die an die Trägerschicht gestellten Anforderungen in Hinblick auf den elektrischen Widerstand bzw. die Leitfähigkeit und die Temperaturwechselbeständigkeit sichergestellt.

Insbesondere ist es vorgesehen, dass die Durchgangsaussparung teilweise, insbesondere nur partiell, mit der Paste gefüllt wird, wobei die Durchgangsaussparung zeitlich vor dem Anbindungsverfahren vorzugsweise zwischen 20 % und 90 %, bevorzugt zwischen 40 % und 80 % und besonders bevorzugt zwischen 60 und 75 % gefüllt ist. Es hat sich überraschender Weise herausgestellt, dass eine partielle Füllung der Durchgangsbohrung ausreicht, um prozesssicher eine elektrisch leitende Verbindung durch die gefertigte Durchkontaktierung zu realisieren. Vorzugsweise wird die Durchgangsaussparung dabei mit einem Siebdruckverfahren und/oder einem 3D Druckverfahre nur partiell gefüllt. Bei der partiellen Füllung wird dabei vorzugsweise darauf geachtet, dass die Innenseite der Durchgangsaussparung bedeckt wird. Dadurch kann sichergestellt werden, dass eine elektrisch leitende Verbindung durch die Paste nach dem Anbindungsverfahren bereitgestellt werden kann. Beispielsweise wird die Innenseite gezielt bedeckt bzw. bestrichen oder die leicht verflüssige Paste wird während des Anbindungsverfahrens an die Innenseite geführt. Hierzu könnte man beispielsweise die Trägerschicht neigen. Weiterhin ist es vorstellbar, dass die Durchgangsaussparung zunächst vollständig befüllt werden und anschließend vor dem Anbindungsverfahren ein Teil der Paste wieder aus der Durchgangsaussparung wieder entnommen wird.

In einer weiteren Ausführungsform der vorliegenden Erfindung ist es vorgesehen, dass die Durchgangsaussparung nach dem Anbindungsverfahren teilweise mit einem elektrisch leitenden Material gefüllt ist, wobei die Durchgangsaussparung zeitlich vor dem Anbindungsverfahren vorzugsweise zwischen 20 % und 80 %, bevorzugt zwischen 40 % und 75 % und besonders bevorzugt zwischen 60 und 70% gefüllt ist. Beispielsweise handelt es sich bei dem leitenden Material um ein Metall, insbesondere Kupfer. Insbesondere ist es vorgesehen, dass der Füllgrad während des Anbindungsprozesses reduziert wird. Mit anderen Worten: es verflüchtig sich ein Teil der in der Durchgangsaussparung eingelassenen Paste während des Anbindungsprozesses. Es ist auch vorstellbar, dass die Paste bzw. die Zusammensetzung der Paste und/oder der Anbindungsprozess derart gestaltet sind, dass gezielt mit einer bestimmten Reduktion des Füllgrads zu rechnen ist und so die Leitfähigkeit der Durchkontaktierung eingeschränkt wird.

Vorzugsweise ist es vorgesehen, dass die Durchgangsaussparung konisch geformt ist. Durch die konische Ausformung lässt sich ein Einfließen der Paste von der Trägerschicht in die Durchgangsaussparung unterstützen und so beispielsweise lässt sich über einen Neigungsgrad der Durchgangsaussparung die Füllung während des Anbindungsverfahrens kontrolliert einstellen.

In einer weiteren Ausführungsform der vorliegende Erfindung ist es vorgesehen, dass die Paste
- derart auf der Trägerschicht angeordnet und/oder konfiguriert wird, dass am Rand der Durchgangsaussparung angeordnete Paste von der Trägerschicht in die Durchgangsaussparung einfließt während des Anbindungsverfahrens und/oder
- mittels Siebdruckverfahren in der Durchgangsaussparung angeordnet wird. Beispielsweise ist es vorstellbar, dass die Durchgangsaussparung derart dimensioniert ist, dass durch einen Adhäsionseffekt während des Anbindungsverfahrens die Paste in die Durchgangsaussparung gelang bzw. hineingezogen wird. Auch eine Bewegung der Trägerschicht kann zum Einfließen der Paste unterstütz oder veranlasst wird.

Vorzugsweise ist es vorgesehen, dass ein Anteil eines elektrisch leitenden Materials in der Paste zu der gesamten Paste einen Wert zwischen 0,2 und 0,8, bevorzugt zwischen 0,35 und 0,75 und bevorzugt zwischen 0,4 und 0,6 annimmt. Dadurch lassen sich in vorteilhafter Weise gezielt die elektrische Leitfähigkeit und der Füllgrad der Durchgangsbohrung beeinflussen.

Ein weiterer Gegenstand der vorliegenden Erfindung ist eine Trägerschicht mit Durchkontaktierung, insbesondere hergestellt mit einem Verfahren gemäß einem der vorhergehenden Ansprüche, umfassend:
- eine Keramik umfassende Trägerschicht
- eine in die Trägerschicht eingelassene Durchgangsbohrung,
wobei die Durchgangsbohrung zumindest teilweise mit Metall gefüllt ist, dass zur elektrischen Leitung beitragen kann, vorzugsweise zwischen 20 % und 100 %, bevorzugt zwischen 40 % und 100 % und besonders bevorzugt zwischen 60 und 100 % gefüllt ist. Alle für das erfindungsgemäße Verfahren beschriebenen Merkmale und deren Vorteile lassen sich sinngemäß ebenfalls auf die erfindungsgemäße Trägerschicht übertragen und andersherum.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig.1a bis 1d:**: ein Verfahren zur Herstellung einer Durchkontaktierung in einer aus einer Keramik gefertigten Trägerschicht gemäß einer beispielhaften Ausführungsform der vorliegenden Erfindung
- **Fig. 2:**: eine Draufsicht auf eine Trägerschicht mit einer Durchkontaktierung gemäß einer beispielhaften Ausführungsform der vorliegenden Erfindung.

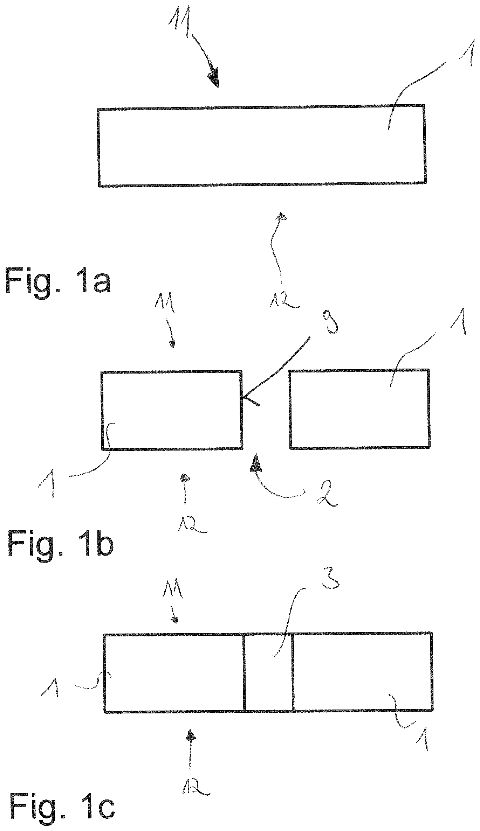

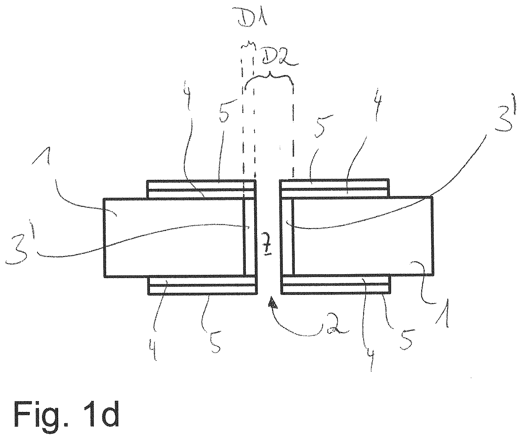

In den **Figuren 1a bis 1d** ist ein Verfahren zur Herstellung einer Durchkontaktierung 3' in einer aus einer Keramik gefertigten Trägerschicht 1 gemäß einer beispielhaften Ausführungsform der vorliegenden Erfindung dargestellt. Hierbei handelt es sich vorzugsweise um ein für Spezialanwendungen vorteilhafte keramikhaltige Trägerschicht 1, die als Träger für elektrische bzw. elektronische Bauteile vorgesehen ist. Zur elektrisch leitenden Verbindung der einzelnen elektrischen bzw. elektronischen Bauteile sind dabei insbesondere Metallisierungen zur Ausbildung von Leiterbahnen an einer Trägeroberseite 11 vorgesehen. Zur Reduktion von parasitären Induktionseffekten und zur optimalen Ausnutzung der Trägerschicht 1 ist es mit Vorteil vorgesehen, zusätzlich zu den Metallisierungen auf der Trägeroberseite 11 auch Metallisierungen auf der der Trägeroberseite 11 gegenüberliegenden Trägerunterseite 12 anzuordnen. Zur Verbindung der Metallisierungen bzw. einer Metallisierung 5 auf der Trägeroberseite 11 mit denen auf der Trägerunterseite 12 ist vorzugsweise eine Durchkontaktierung 3' vorgesehen. Zur Ausbildung der Durchkontaktierung 3' wird vorzugsweise zunächst eine Durchgangsaussparung 2, insbesondere eine Durchgangsbohrung, in die Keramik umfassende Trägerschicht 1 eingelassen, wie es in Figur 1b dargestellt ist. Dabei weist die Durchgangsaussparung einen Durchmesser D2 auf. Anschließend wird in die Durchgangsaussparung 2 eine Paste 3 eingelassen (siehe Figur 1c). Dabei handelt es sich bei der Paste 3 vorzugsweise um eine ein Aktivlotmaterial und/oder ein Kupfer umfassende Paste. Bevorzugt ist es vorgesehen, dass die Paste 3 eine Innenseite 9 der Durchgangsaussparung 2 zumindest teilweise, bevorzugt vollständig bedeckt.

Ferner ist es vorgesehen, dass die Metallisierung an der Trägeroberseite 11 und an der Trägerunterseite 12 mittels eines Aktivlotverfahrens unter Verwendung eines Aktivlots 4 angebracht wird. Dabei ist es vorgesehen, dass im Rahmen des Anbindungsprozesses mittels des Aktivlotverfahrens die Durchkontaktierung 3' aus der Paste 3 in der Durchgangsaussparung 2 gebildet wird. Dadurch lässt sich mit Vorteil in einem Verfahrensschritt die Durchkontaktierung 3' zusammen mit dem Anbindungsprozess der Metallisierung bzw. Metallisierung 5 realisieren. Vorzugsweise ist es vorgesehen, dass die Durchkontaktierung 3' durch eine an einer Innenseite 9 der Durchgangsbohrung anliegenden Beschichtung mit einer Beschichtungsdicke D1 gebildet wird. Insbesondere sind im fertigen Zustand in der Durchgangsaussparung 2 die an der Innenseite 9 anliegende Beschichtung und ein beschichtungsfreier Kernbereich 7 angeordnet. Vorzugsweise lässt sich mittels des Volumenverhältnisses aus anliegender Beschichtung und beschichtungsfreiem Kernbereich 7 eine elektrische Leitfähigkeit der Durchkontaktierung 3' gezielt einstellen. Weiterhin ist es vorzugsweise vorgesehen, dass sich die Metallisierung 5 über den beschichtungsfreien Kernbereich 7 erstreckt, insbesondere den beschichtungsfreien Kernbereich vollständig bedeckt.

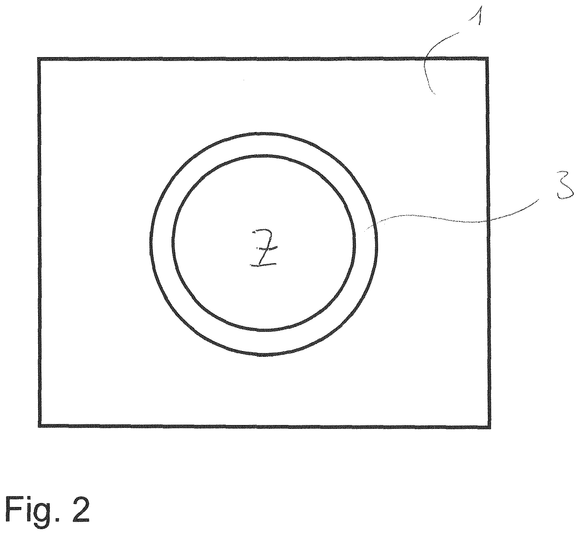

In der **Figur 2** ist eine Draufsicht auf eine Trägerschicht 1 bzw. ein Schnitt durch die Trägerschicht 1 mit einer Durchkontaktierung 3' gemäß einer beispielhaften Ausführungsform der vorliegenden Erfindung dargestellt. In der Draufsicht erkennt man die an der Innenseite 9 der Durchgangsaussparung 2 angeordnete Beschichtung, die den beschichtungsfreien Kernbereich 7 ummantelt bzw. umgibt. Vorzugsweise weist der beschichtungsfreie Kernbereich 7 einen Radius auf, wobei das Verhältnis des Radius des beschichtungsfreien Kernbereichs 7 zum Innenradius der Durchgangsaussparung 2 einen Wert zwischen 0,2 und 0,9, bevorzugt zwischen 0,4 und 0,8 und besonders bevorzugt zwischen 0,5 und 0,7 annimmt.

### Bezugszeichen:

- 1: Trägerschicht
- 2: Durchgangsaussparung
- 3: Paste
- 3': Durchkontaktierung
- 4: Aktivlot
- 5: Metallisierung
- 7: Kernbereich
- 9: Innenseite
- 11: Trägeroberseite
- 12: Trägerunterseite
- D1: Beschichtungsdicke
- D2: Durchmesser

## Patentansprüche

1. Verfahren zur Herstellung einer Durchkontaktierung (3') in einer aus einer Keramik gefertigten Trägerschicht (1), umfassend:
- Bereitstellen der Trägerschicht (1),
- Realisieren einer Durchgangsaussparung (2) in der Trägerschicht (1),
- zumindest teilweises Füllen der Durchgangsaussparung (2) mit einer Paste (3) und
- Durchführen eines Anbindungsverfahrens zur Anbindung einer Metallisierung (5) an die Trägerschicht (1) mittels eines Aktivlot-Verfahrens oder eines DCB-Verfahrens,
**dadurch gekennzeichnet, dass** beim Durchführen des Anbindungsverfahrens aus der Paste (3) in der Durchgangsaussparung (2) die Durchkontaktierung (3') realisiert wird.

2. Verfahren gemäß Anspruch 1, wobei durch das Verfahren ein bestimmter elektrischer Widerstand der Durchkontaktierung (3') eingestellt wird.

3. Verfahren gemäß einem der vorhergehenden Ansprüche, wobei ein elektrischer Widerstand der Durchkontaktierung (3') durch Einstellen eines oder mehrerer Prozessparameter des Anbindungsverfahrens eingestellt wird.

4. Verfahren gemäß einem der vorhergehenden Ansprüche, wobei eine Innenseite (9) der Durchgangsaussparung (2) mit einer Paste (3) bedeckt wird, wobei die Durchgangsaussparung (2) vorzugsweise zumindest teilweise gefüllt ist.

5. Verfahren gemäß einem der vorhergehenden Ansprüche, wobei die Durchgangskontaktierung (3') als Beschichtung der Innenseite (9) der Durchgangsaussparung (2) mit einer Beschichtungsdicke (D1) ausgebildet wird, wobei das Anbindungsverfahren derart konfiguriert ist, dass sich eine bestimmte Beschichtungsdicke einstellt.

6. Verfahren gemäß einem der vorhergehenden Ansprüche, wobei eine Paste (3) mit Zusatzmaterial verwendet wird.

7. Verfahren gemäß Anspruch 6, wobei das Zusatzmaterial Indium, Zinn und/oder Gallium umfasst, vorzugweise in einer Konzentration von 0,1 bis 20 Gew. - %.

8. Verfahren gemäß einem der vorhergehenden Ansprüche, wobei die metallischen Bestandteile der Paste (3) mittels einem Druckverfahren und/oder einem Siebdruckverfahren und/oder einem Schablonendruckverfahren aufgetragen wird.

9. Verfahren gemäß einem der vorhergehenden Ansprüche, wobei die Durchgangsaussparung (2) einen Durchmesser (D2) bzw. äquivalente Querschnittsfläche zwischen 0,01 mm und 5 mm aufweist.

10. Verfahren gemäß einem der vorhergehenden Ansprüche, wobei die Durchgangsaussparung (2) teilweise mit der Paste (3) gefüllt wird, wobei die Durchgangsaussparung zeitlich vor dem Anbindungsverfahren zwischen 20 % und 90 % gefüllt ist.

11. Verfahren gemäß einem der vorhergehenden Ansprüche, wobei die Durchgangsaussparung (2) nach dem Anbindungsverfahren teilweise mit einem elektrisch leitenden Material gefüllt ist, wobei die Durchgangsaussparung (2) zeitlich vordem Anbindungsverfahren zwischen 20 % und 80 %, gefüllt ist.

12. Verfahren gemäß einem der vorhergehenden Ansprüche, wobei die Durchgangsaussparung (2) konisch geformt ist.

13. Verfahren gemäß einem der vorhergehenden Ansprüche, wobei die Paste (3)
- derart auf der Trägerschicht (1) angeordnet und/oder konfiguriert wird, dass am Rand der Durchgangsaussparung (2) angeordnete Paste von der Trägerschicht (1) in die Durchgangsaussparung (2) während des Anbindungsverfahrens einfließt und/oder
- mittels Siebdruckverfahren in der Durchgangsaussparung (1) angeordnet wird.

14. Verfahren gemäß einem der vorhergehenden Ansprüche, wobei ein Anteil eines elektrisch leitenden Materials in der Paste (3) zu der gesamten Paste (3) einen Wert zwischen 0,2 und 0,8, annimmt.

## Claims

1. A method for producing a via (3') in a support layer (1) made of a ceramic, comprising:
- providing the support layer (1),
- realizing a through-hole (2) in the support layer (1),
- at least partially filling the through-hole (2) with a paste (3) and
- performing an attach procedure for attaching a metallization (5) to the support layer (1) using an active soldering process or a DCB process,
**characterized in that**
when performing the attach procedure, the via (3') will be produced from the paste (3) in the through-hole (2).

2. The method according to claim 1, wherein a specific electrical resistance of the via (3') is adjusted using the method.

3. The method according to one of the preceding claims, wherein an electrical resistance of the via (3') is adjusted by adjusting one or more process parameters of the attach procedure.

4. The method according to one of the preceding claims, wherein an inner side (9) of the through-hole (2) is covered with a paste (3), wherein the through-hole (2) is preferably at least partially filled.

5. The method according to one of the preceding claims, wherein the via (3') is formed as a coating of the inner side (9) of the through-hole (2) with a coating thickness (D1), wherein the attach procedure is configured such that a specific coating thickness will be established.

6. The method according to one of the preceding claims, wherein a paste (3) with additional material is used.

7. The method according to claim 6, wherein the additive material comprises indium, tin and/or gallium, preferably in a concentration of 0.1 to 20% by weight.

8. The method according to one of the preceding claims, wherein the metallic constituents of the paste (3) will be applied using a printing process and/or a screen printing process and/or a stencil printing process.

9. The method according to one of the preceding claims, wherein the through-hole (2) has a diameter (D2) or an equivalent cross-sectional area between 0.01 mm and 5 mm.

10. The method according to one of the preceding claims, wherein the through-hole (2) is partially filled with the paste (3), wherein the through-hole is filled by between 20% and 90% prior to the attach procedure.

11. The method according to one of the preceding claims, wherein the through-hole (2) is partially filled with an electrically conductive material after the attach procedure, wherein the through-hole (2) is filled by between 20 % and 80 % in time prior to the attach procedure.

12. The method according to one of the preceding claims/wherein the through-hole (2) is of conical shape.

13. The method according to one of the preceding claims, wherein the paste (3)
- is arranged and/or configured on the support layer (1) such that during the attach procedure paste arranged at the edge of the through-hole (2) flows from the support layer (1) into the through-hole (2) and/or
- is arranged in the through-hole (2) using screen printing.

14. The method according to one of the preceding claims, wherein a ratio of an electrically conductive material in the paste (3) to the total of paste (3) assumes a value between 0.2 and 0.8.

## Revendications

1. Procédé de réalisation d'un via (3') dans une couche de support (1) fabriquée en céramique, consistant à :
- fournir la couche de support (1),
- ménager une échancrure traversante (2) dans la couche de support (1),
- remplir au moins partiellement l'échancrure traversante (2) avec une pâte (3), et
- mettre en œuvre un procédé de liaison pour lier une métallisation (5) à la couche de support (1) au moyen d'un procédé de brasage actif ou d'un procédé DCB,
**caractérisé en ce que**
lors de la mise en œuvre du procédé de liaison, le via (3') est réalisé à partir de la pâte (3) dans l'échancrure traversante (2).

2. Procédé selon la revendication 1, dans lequel une certaine résistance électrique du via (3') est adaptée par ledit procédé.

3. Procédé selon l'une des revendications précédentes, dans lequel une résistance électrique du via (3') est adaptée en adaptant un ou plusieurs paramètres de processus du procédé de liaison.

4. Procédé selon l'une des revendications précédentes, dans lequel une face intérieure (9) de l'échancrure traversante (2) est recouverte d'une pâte (3), l'échancrure traversante (2) étant de préférence remplie au moins partiellement.

5. Procédé selon l'une des revendications précédentes, dans lequel le via (3') est réalisé sous forme de revêtement de la face intérieure (9) de l'échancrure traversante (2) avec une épaisseur de revêtement (D1), le procédé de liaison étant configuré de manière à adapter une certaine épaisseur de revêtement.

6. Procédé selon l'une des revendications précédentes, dans lequel on utilise une pâte (3) avec un matériau additif.

7. Procédé selon la revendication 6, dans lequel le matériau additif comprend de l'indium, de l'étain et/ou du gallium, de préférence dans une concentration de 0,1 à 20 % en poids.

8. Procédé selon l'une des revendications précédentes, dans lequel les constituants métalliques de la pâte (3) sont appliqués au moyen d'un procédé d'impression et/ou d'un procédé de sérigraphie et/ou d'un procédé d'impression au pochoir.

9. Procédé selon l'une des revendications précédentes, dans lequel l'échancrure traversante (2) présente un diamètre (D2) ou une surface de section transversale équivalente compris(e) entre 0,01 mm et 5 mm.

10. Procédé selon l'une des revendications précédentes, dans lequel l'échancrure traversante (2) est partiellement remplie de la pâte (3), l'échancrure traversante étant de préférence remplie entre 20 % et 90 %, temporellement avant le procédé de liaison.

11. Procédé selon l'une des revendications précédentes, dans lequel l'échancrure traversante (2) est partiellement remplie d'un matériau électriquement conducteur après le procédé de liaison, l'échancrure traversante (2) étant de préférence remplie entre 20 % et 80 %, temporellement avant le procédé de liaison.

12. Procédé selon l'une des revendications précédentes, dans lequel l'échancrure traversante (2) est de forme conique.

13. Procédé selon l'une des revendications précédentes, dans lequel la pâte (3)
- est agencée et/ou configurée sur la couche de support (1) de telle sorte que la pâte agencée au bord de l'échancrure traversante (2) s'écoule de la couche de support (1) jusque dans l'échancrure traversante (2) pendant le procédé de liaison, et/ou
- est agencée dans l'échancrure traversante (1) par un procédé de sérigraphie.

14. Procédé selon l'une des revendications précédentes, dans lequel une proportion d'un matériau électriquement conducteur dans la pâte (3) par rapport à la totalité de la pâte (3) prend une valeur comprise entre 0,2 et 0,8.
